# EUROPÄISCHE PATENTSCHRIFT

(11) **EP 1 019 964 B1**
(45) Veröffentlichungstag und Bekanntmachung des Hinweises auf die Patenterteilung: **05.06.2002**
(21) Anmeldenummer: 98954238.6
(22) Anmeldetag: 29.09.1998
(51) Int. Cl.: H01L 27/02, H01L 27/082

(54) **INTEGRIERTE HALBLEITERSCHALTUNG MIT SCHUTZSTRUKTUR ZUM SCHUTZ VOR ELEKTROSTATISCHER ENTLADUNG**
INTEGRATED CIRCUIT WITH SEMICONDUCTOR COMPRISING A STRUCTURE FOR PROTECTION AGAINST ELECTROSTATIC DISCHARGES
CIRCUIT INTEGRE A SEMICONDUCTEUR COMPORTANT UNE STRUCTURE SERVANT A LA PROTECTION CONTRE DES DECHARGES ELECTROSTATIQUES

(30) Priorität: 30.09.1997 DE 19743232
(43) Veröffentlichungstag der Anmeldung: 19.07.2000
(73) Patentinhaber: Infineon Technologies AG, 81669 München (DE)
(72) Erfinder: GOSSNER, Harald, D-81735 München (DE)
(74) Vertreter: Barth, Stephan Manuel, Dr.
(86) Internationale Anmeldenummer: DE9802880
(87) Internationale Veröffentlichungsnummer: WO9917369

(56) Entgegenhaltungen:
- EP-A- 0 492 032
- EP-A- 0 768 713
- EP-A- 0 785 576
- US-A- 5 602 409
- PATENT ABSTRACTS OF JAPAN vol. 7, no. 166 (E-188), 21. Juli 1983 & JP 58 074081 A (NIPPON DENKI K.K), 4. Mai 1983
- PATENT ABSTRACTS OF JAPAN vol. 11, no. 20 (E-472), 20. Januar 1987 & JP 61 190973 A (HITACHI MICRO COMPUT ENG), 25. August 1986
- PATENT ABSTRACTS OF JAPAN vol. 10, no. 221 (E-424), 2. August 1986 & JP 61 056458 A (MATSUSHITA ELECTRONICS ), 22. März 1986

## Beschreibung

Die vorliegende Erfindung betrifft eine integrierte Halbleiterstruktur mit Schutzstruktur zum Schutz vor elektrostatischer Entladung gemäß dem Oberbegriff des Anspruchs 1, wie aus der EP-A-0,785,576 bekannt.

Derartige integrierte Halbleiterschaltungen sind auch aus der EP-A-0,492,032 und aus der JP-A-58074081 bekannt.

Ein weiteres sogenanntes ESD-Schutzelement ist aus der EP 0 414 934 A1 bekannt.

In einem Chip integrierte Halbleiterschaltungen enthalten Schutzschaltungen zum Schutz der Ein- oder Ausgänge (I/O-Ports) gegen elektrostatische Überspannungen und dadurch verursachte elektrostatische Entladungen (Electrostatic Discharge (ESD)). Diese sogenannten ESD-Schutzelemente sind zwischen dem Eingangspad einer integrierten Halbleiterschaltung und. dem zu schützenden Eingangs- oder Ausgangsanschluß angeschlossen und sorgen somit dafür, daß bei Einkopplung einer parasitären Überspannung das ESD-Schutzelement durchschaltet und der parasitäre Überspannungsimpuls somit an eine der Versorgungsspannungsleiterbahnen abgeleitet wird. Derartige Überspannungsimpulse können im Extremfall zur Zerstörung des Bauteiles führen.

Unter Operationsbedingungen, wie sie z. B. in der Produktspezifikation beschrieben sind, dürfen die ESD-Schutzelemente die Funktion der zu schützenden integrierten Halbleiterschaltungen jedoch nicht beeinträchtigen. Das bedeutet, daß die Durchschaltspannung der ESD-Schutzelemente außerhalb des Signalspannungsbereiches der geschützten Anschlußpads liegen muß. Um eine gute Schutzwirkung entfalten zu können, sollte das ESD-Schutzelement vor dem kritischsten Schaltungspfad durchbrechen. Dies erfordert in der Regel eine exakte Einstellung der Durchschaltspannung der jeweiligen ESD-Schutzelemente mit der wesentlichen Randbedingung, daß die Prozeßführung, die hinsichtlich der Eigenschaften der Bauelemente der zu schützenden integrierten Halbleiterschaltung optimiert wurde, durch das Einfügen der ESD-Schutzelemente nicht verändert wird.

Eine weitere wesentliche Randbedingung ergibt sich aus der räumlichen Anordnung der Anschlußpads in unmittelbarer Nähe der zu schützenden integrierten Halbleiterschaltung. Insbesondere werden die Anschlußpads wegen des relativ hohen zu treibenden Strom in der Nähe der Ausgangstreiber angeordnet. Die ESD-Schutzstruktur wird daher häufig an diejenige Versorgungsleitung angeschlossen, aus der der Ausgangstreiber versorgt wird.

Wesentlich für die Funktionsweise von gattungsgemäßen ESD-Schutzelementen ist die Fähigkeit, kurze Hochstrompulse bis in den Amperebereich ableiten zu können, ohne durch diese Hochstromimpulse geschädigt zu werden. Während des ESD-Pulses werden die Schutzelemente im Durchbruch betrieben. Da die Schutzelemente an allen Versorgungs- und Signalanschlüsse anzubringen sind, müssen sie möglichst kompakt und platzsparend entworfen werden. Dies erfordert gleichzeitig, daß der abzuleitende Strom sich möglichst gleichmäßig über die gesamte Durchbruchstrecke verteilt, um so bis zu einer kritischen Stromdichte, die zu einer Schädigung des Schutzelements führen kann (Second-Break-Down), einen möglichst hohen Gesamtstrom über das Schutzelement und damit eine hohe ESD-Festigkeit zu erzielen.

Insbesondere bei Schutzelementen, die im Durchbruch ein sogenanntes Snap-Back-Verhalten der Kennlinie aufweisen, wie z.B. Bipolartransistoren oder Thyristoren, besteht die Gefahr, daß eine Stelle der Durchbruchstrecke bzw. ein Finger einer Multifingerstruktur zündet und den Strom ableitet, ohne daß die übrigen Bereiche der Durchbruchstruktur bzw. die übrigen Finger durchschalten. Durch diesen Effekt werden oftmals die Schutzelemente und die nachgeschalteten zu schützenden integrierten Schaltungen zerstört.

Die Ursache für dieses inhomogene Durchschalten sind mitunter sehr große Potentialunterschiede in der Basiszone der Schutzelemente. Diese Potentialunterschiede ergeben sich aus dem sehr hohen Schichtwiderstand der Basis und den hohen abzuleitenden Strömen. Eine Verbesserung läßt sich in der Regel nur durch eine geeignete metallische Verbindung der Basisgebiete untereinander, insbesondere bei Fingerstrukturen, erzielen. Dazu ist jedoch eine Kontaktierung der Basisgebiete erforderlich. Dies ist jedoch mit großem Flächenaufwand verbunden. Zudem wird abhängig von Designvorgaben und Technologieparametern der Grad der erzielbaren Homogenisierung sehr unterschiedlich sein.

Bezüglich weiterer Einzelheiten, Merkmale, deren Vorteile und Wirkungsweise der ESD-Schutzschaltungen wird ausdrücklich auf die Europäische Patentanmeldung EP 0 623 958 A1 sowie auf die eingangs erwähnte EP 0 414 934 A1 verwiesen.

Ausgehend von diesem Stand der Technik liegt der Erfindung daher die Aufgabe zugrunde, eine ESD-Schutzstruktur der eingangs genannten Art bereitzustellen, die eine deutlich verbesserte Homogenisierung des Stromflusses im Durchbruch aufweist.

Erfindungsgemäß wird diese Aufgabe durch eine integrierte Halbleiterschaltung mit den Merkmalen des Patentanspruchs 1 gelöst.

Es werden integrierte, vertikale Schalttransistoren als ESD-Schutzelemente genutzt, deren Basis durch integrierte Ansteuertransistoren angesteuert werden. Wesentlich ist hier, daß die Stromverstärkung (Basis-Kollektor-Verstärkung) der Ansteuertransistoren hinreichend klein ist, um das Zünden des parasitären Thyristors, der sich aus der Veischaltung der Schalttransitoren und der Ansteuertransistoren ergibt, mit einem unerwünschten Zurückspringen der Hochstromkennlinie auf die Haltespannung zu vermeiden. Durch geeignete Wahl der Basisweiten der Ansteuertransistoren läßt sich vorteilhafterweise die Durchschaltspannung des ESD-Schutzlements einstellen.

Erfindungswesentlich ist dabei eine möglichst niederchmig ausgebildete vergrabene Schicht. Der Schichtwiderstand der vergrabenen Schicht definiert einen integrierten Widerstand, der zwischen den Basisanschlüssen der Absteuertransistoren und den Kollektoranschlüssen der Schalttransistoren angeordnet ist und der eine Homogenisierung des Stromflusses im Durchbruch ermöglicht.

Die vergrabene Schicht ist dabei über eine Anschlußzone, die aus Gründen einer guten Leitfähigkeit möglichst hoch dotiert ist, mit dem Anschlußpad verbunden. Die Anschlußzone definiert dabei einen Teilbereich, in dem die Schutzelemente angeordnet sind. Typischerweise ist der Teilbereich in einer Epitaxieschicht angeordnet. Besonders vorteilhaft ist es, wenn die Anschlußzone als geschlossener Ring um den Teilbereich angeordnet ist.

Die Anschlußzonen sind dabei äquidistant durch einen zweiten Abstand von den Basiszonen und/oder von den zweiten Emitterzonen beabstandet. Der zweite Abstand ist typischerweise ausreichend groß zu wählen, so daß der parasitäre Bipolartransistor im Randbereich der Teilzone nicht durchschaltet.

Ein zweiter integrierter Widerstand, über den die Ansteuersensibilität der Ansteuertransistoren einstellbar ist, ist im wesentlichen abhängig von der Dotierungskonzentration in der Anschlußzone. Zusätzlich hängt der zweite Widerstand noch von Kontaktwiderständen der elektrischen Anschlüsse ab.

Typischerweise ist die laterale Querschnittsfläche der vergrabenen Schicht größer als die laterale Querschnittsfläche der Anschlußzone und des Teilbereichs.

Typischerweise weisen die Emitterzonen eine sehr viel höhere Dotierungskonzentration auf, als die Basiszonen bzw. die Epitaxieschicht. Die Dotierungskonzentration in der Epitaxieschicht ist oftmals von der Prozeßführung zur Herstellung der integrierten Schaltung festgelegt.

Die vergrabenen Schicht und die Anschlußzonen sind um den Anforderungen eines sehr hohen Leitwertes Genüge zu leisten, sehr hoch dotiert. Typischerweise weisen diese Zonen eine Dotierungskonzentration von mehr als 1*10¹⁹ cm⁻³ auf.

Besonders vorteilhaft ist die Erfindung bei Verwendung in einem Halbleiterspeicher oder einem Logikbauteil. Eine weitere vorteilhafte Anwendung findet die Erfindung in der Verwendung in einem Mikrokontroller.

Typischerweise ist die Erfindung in bipolar realisierten Schaltungen integrieit. Dabei kann der Schalttransistor ein npn-Bipolartransistor sein und der Ansteuertransistor ein pnp-Bipolartransistor. Besonders vorteilhaft ist es jedoch, wenn die integrierte Halbleiterschaltung sowie das ESD-Schutzelement in CMOS-Technologie hergestellt ist. In diesem Fall ist der Schalttransistor beispielsweise ein n-Kanal MOSFET und der Ansteuertransistor ein p-Kanal MOSFET.

Vorteilhafte Ausgestaltungen und Weiterbildungen sind Gegenstand der Unteransprüche.

Nachfolgend wird die Erfindung anhand der in den Figuren der Zeichnung angegebenen Ausführungsbeispiele näher erläutert. Es zeigt dabei:
- Figur 1: die Schaltungsanordnung einer bekannten integrierten Halbleiterschaltung mit vorgeschaltetem ESD-Schutzelement;
- Figur 2: in einem Teilschnitt ein erstes Ausführungsbeispiel einer erfindungsgemaßen ESD-Schutzstruktur in einem Halbleitersystem;
- Figur 3: in einem Teilschnitt ein zweites Ausführungsbeispiel einer erfindungsgemäßen ESD-Schutzstruktur;
- Figur 4: in einem Teilschnitt ein drittes Ausführungsbeispiel einer erfindungsgemäßen ESD-Schutzstruktur;
- Figur 5: eine Draufsicht der in Figur 2 gezeigten Struktur.

In allen Figuren der Zeichnung sind gleiche oder funktionsgleiche Elemente, sofern dies nicht anders angegeben ist, mit gleichen Bezugszeichen versehen.

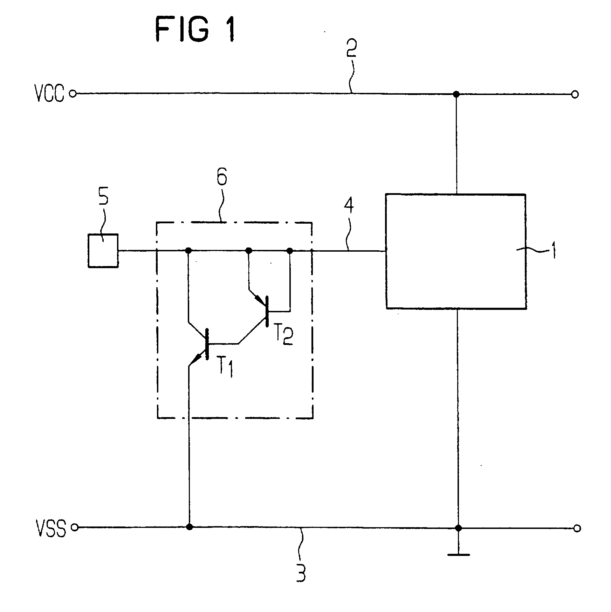

Figur 1 zeigt eine Schaltungsanordnung einer bekannten integrierten Halbleiterschaltung mit vorgeschaltetem ESD-Schutzelement.

In Figur 1 ist mit 1 die integrierte Halbleiterschaltung bezeichnet. Die integrierte Halbleiterschaltung 1 ist an eine erste Potentialschiene 2 mit einem ersten Versorgungspotential VCC sowie eine zweite Fotentialschiene 3 mit einem zweiten Versorgungspotential VSS angeschlossen. Das erste Versorgungspotential VCC kann beispielsweise die Versorgurgsspannung sein. Das zweite Versorgungspotential VSS kann wie im vorliegenden Beispiel die Bezugsmasse sein.

Über eine Verbindungsieitung 4 ist die integrierte Halbleiterschaltung 1 mit einem Anschlußpad 5 verbunden. Das Anschlußpad 5 kann sowohl ein Eingangsanschluß zur Einkopplung von Eingangssignalen in die integrierte Halbleiterschaltung 1 sein, als auch ein Ausgangsanschluß zum Auskoppeln von Ausgangssignalen aus der integrierten Halbleiterschaltung 1. Derartige Anschlüsse werden auch als I/O-Ports bezeichnet.

Zwischen das Anschlußpad 5 und der integrierten Halbleiterschaltung 1 ist ein ESD-Schutzelement 6 geschaltet. Außerdem ist das ESD-Schutzelement 6 mit der zweiten Potentialschiene 3 verbunden.

Das ESD-Schutzelement 6 in Figur 1 besteht aus einem ersten Transistor T1 und einem zweiten Transistor T2. Die Transistoren T1, T2 sind von unterschiedlichem Typ, d. h. der erste Transistor ist im vorliegenden Beispiel ein npn-Transistor und der zweite Transistor ist ein pnp-Transistor. Deren Basisanschlüsse und Kollektoranschlüsse sind gegenseitig zu einer Thyristcrstruktur gekoppelt. Im vorliegenden Beispiel sind die Transistoren T1, T2 bipolar realisiert. Es wäre natürlich auch denkbar die beiden Transistoren T1, T2 als MOS-FETs, als Sperrschicht-FETs, als Thyristoren oder als IGBTs, die geeignet verschaltet sind, zu realisieren.

Im vorliegenden Beispiel ist das ESD-Schutzelement 6 zwischen der Anschlußleitung 4 und der zweiten Potentialschiene 3 geschaltet. Es wäre selbstverständlich auch denkbar, das ESD-Schutzelement zwischen der Verbindungsleitung 4 und der ersten Potentialschiene bzw. zwischen der Verbindungsleitung 4 und beiden Potentialschienen 2, 3 anzuordnen.

Das ESD-Schutzelement 6 soll die integrierte Halbleiterschaltung 1 vor parasitären, über das Anschlußpad 5 eingekoppelten Störsignalen schützen. Diese parasitären Störsignale werden durch das ESD-Schutzelement 6 an eine der Potentialschienen 2, 3 abgeleitet und gelangen somit nicht in die integrierte Halbleiterschaltung 1.

Derartige Störsignale können beispielsweise beim Transport bzw. beim Handling des Halbleiterchips entstehen. Dadurch kann der Halbleiterchip elektrostatisch aufgeladen werden. Wird die elektrostatische Ladung in die integrierte Halbleiterschaltung 1 eingekoppelt, kann dies im Extremfall zur Zerstörung der integrierten Halbleiterschaltung 1 führen.

Zur Simulierung einer Störsignaleinkopplung wird typischerweise das sogenannte Human-Body-Modell (HBM) angewendet. Das Ersatzschaltbild des Human-Body-Modells sieht einen Tiefpaß, bestehend aus einer Kapazität von 100 pF und einem Widerstand von 1,5 KΩ vor. Das Human-Body-Modell simuliert ein durch einen Menschen eingekoppeltes Störsignal. Es ist auch denkbar, andere Modelle wie beispielsweise das sogenannte Charged-Device-Modell (CDM) zu verwenden.

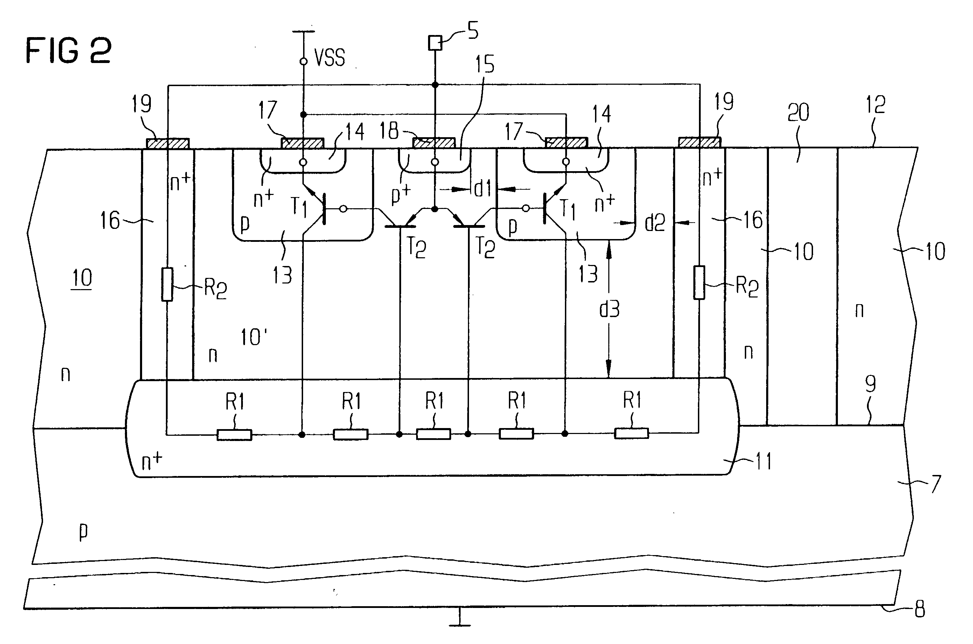

Figur 2 zeigt in einen Teilschnitt ein erstes Ausführungsbeispiel eines ESD-Schutzelements, das im vorliegenden Beispiel durch zwei zu einer Thyristorstruktur verschaltete Bipolartransistoren ausgebildet ist.

In Figur 2 ist mit 7 ein Halbleiterkörper bezeichnet. Der Halbleiterkörper 7 besteht typischerweise aus Silinumsubstrat. Der Halbleiterkörper 7 weist eine Scheibenrückseite 8 und eine Substratoberfläche 9 auf. Die Scheibenrückseite 8 kann beispielsweise über eine gängige großflächige Metallisierung auf dem Bezugspotential liegen. Im vorliegenden Beispiel ist das Siliziumsubstrat des Halbleiterkörpers 7 p-dotiert und liegt auf der Scheibenrückseite 8 auf dem Potential der Bezugsmasse. Es ist selbstverständlich auch denkbar, daß das Halbleitersubstrat n-dotiert ist.

Auf der Substratoberfläche 9 des Halbleiterkörpers 7 ist eine schwach n-dotierte Epitaxieschicht 10 aufgebracht. Für die Funktion der ESD-Schutzstruktur wäre es auch denkbar mehrere Epitaxieschichten 10 übereinander anzuordnen oder auf die Epitaxieschicht 10 ganz zu verzichten. Die Dotierungskonzentration in der Epitaxieschicht 10 ist von der Prozeßführung zur Herstellung der integrierten Halbleiterschaltung 1 festgelegt. Typischerweise weist die Epitaxieschicht eine Dotierungskonzentration von 1*10¹⁵ cm⁻³ bis 1*10¹⁸ cm⁻³ auf

Zusätzlich ist, wie in Figur 2 gezeigt, eine vergrabene Schicht 11 vorgesehen. Eine derartige vergrabene Schicht 11 wird auch als Burried-Layer bezeichnet. Im vorliegenden Beispiel ist die vergrabene Schicht 11 n+-dotiert. Die vergrabene Schicht 11 kann beispielsweise durch Einbringen eines Depots auf der Substratoberfläche 9 vor Aufwachsen der Epitaxieschicht 10 und anschließender Diffusion bei geeigneter Temperatur erzeugt werden.

Es ist jedoch auch vorteilhaft, wenn die vergrabene Schicht 11 durch Ionenimplantation in den Halbleiterkörper 7 nach Aufwachsen bzw. während dem Aufwachsen der Epitaxieschicht 10 erzeugt wird. Um das gewünschte vertikale Profil zu erzielen, ist hierbei häufig eine Mehrfachimplantation bei geeigneten Energien und Dotierungsdosen erforderlich. Hieran sollte ein Temperaturschritt zur homogenen Verteilung der Dotieratome in dem Diffusionsgebiet 9 angeschlossen werden.

Die Dotierungskonzentration in der vergrabenen Schicht 11 ist ebenfalls oftmals durch die Prozeßführung bei der Herstellung der integrierten Schaltung 1 vorgegeben. Erfindungswesentlich ist jedoch, daß die vergrabene Schicht 11 möglichst niederohmig ausgebildet ist. Aufgrund dessen weist die vergrabene Schicht 16 typischerweise eine Dotierungskonzentration von größer 10¹⁹ cm⁻³ auf. Die Dicke der Epitaxieschicht 10 variiert ja nach Technologie zwischen 1-10 µm.

Die vergrabene Schicht 11 ist über Anschlußzonen 16 mit der Scheibenvorderseite 12 des Halbleiterkörpers 1 verbunden. Die Anschlußzone 16 ist vom selben Leitungstyp wie die vergrabene Schicht 11 und weist eine möglichst hohe Dotierungskonzentration von größer 1*10¹⁹ cm⁻³ auf. Die Anschlußzone 16 erstreckt sich im vorliegenden Beispiel von der Scheibenoberfläche 12 in den Halbleiterkörper 7 hinein und ist an die vergrabene Schicht 11 angeschlossen. Die Anschlußzonen 16 sind hier als tiefe Implantationsschicht ausgebildet, können jedoch auch als Graben in bekannter Trench-Technologie ausgebildet werden.

In der Draufsicht beschreiben die Anschlußzonen 16 eine ringförmige Struktur. Die ringförmige Struktur muß jedoch nicht notwendigerweise geschlossen sein. Die ringförmige Struktur der Anschlußzone 16 kann kreisförmig, reckeckig oder vielekkig ausgebildet sein. Die vergrabene Schicht 11 einerseits und andererseits die Anschlußzonen 16 umfassen einen sogenannten Teilbereich 10' der Epitaxieschicht 10.

Im Teilbereich 10' sind an der Scheibenoberfläche 12 zwei Basiszonen 13 angeordnet. Die Basiszonen 13 sind im vorliegenden Ausführungsbeispiel p-dotiert und wannenförmig ausgebildet. Zusätzlich sind innerhalb der Basiszonen 13 an der Scheibenoberfläche 12 wannenförmige erste Emitterzonen 14 vom entgegengesetzten Leitungstyp angeordnet. Die ersten Emitterzonen 14 sind mittig in den Basiszonen 13 angeordnet und weisen im vorliegenden Beispiel eine sehr hohe Dotierungskonzentration auf. Zwischen benachbarten Basiszonen 13 sind zweite Emitterzonen 15 vorgesehen. Die zweiten Emitterzonen 15 sind p+-dotiert und ebenfalls wannenförmig an der Scheibenoberfläche 12 angeordnet. Es wäre auch denkbar, die zweiten Emitterzonen 15 zwischen Basiszone 13 und Anschlußzone 16 anzuordnen.

Die erste und zweite Emitterzonen 14, 15 weisen typischerweise eine Dotierungskonzentration von 5*10¹⁹ cm⁻³ auf. Das Implantationsprofil der Emitterzonenwannen ragt etwa 1µm in den Halbleiterkörper 7 hinein. Die Basiszone weist eine typische Dotierungskonzentration von 10¹⁶ - 10¹⁷cm⁻³ auf, wobei deren Wanne eine Tiefe von etwa 2,5 µm aufweist. Die obengenannten Werte sind typisch für SPT-Bauelemente. Bei Hochfrequenzanwendungen liegen diese Werte im Sub-Micrometerbereich.

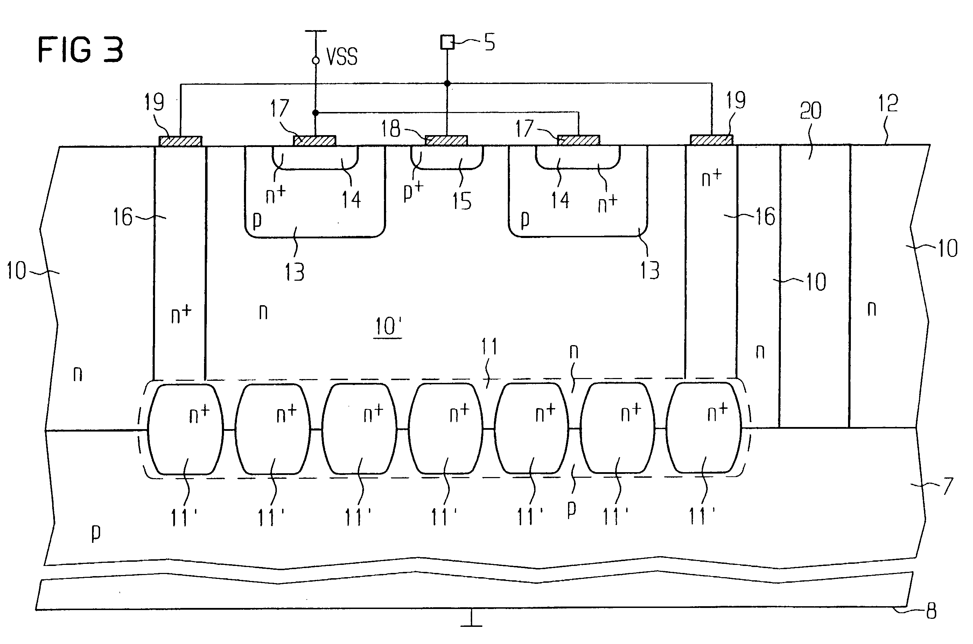

Die Basiszonen 13 und die zweiten Emitterzonen sind in dem Teilbereich 10' in einer sogenannten Fingerstruktur entsprechend Figur 3 angeordnet. Denkbar wäre auch eine mäanderförmige, konzentrische oder ähnliche Struktur. Die Fingerstruktur weist vorteilhafterweise eine Vielzahl von Basiszonen 13 und eine Vielzahl von zweiten Emitterzonen 15 auf. Der Übersichtlichkeit halber sind in Figur 2 jedoch nur zwei Basiszonen 13 und eine zweite Emitterzone 15 dargestellt.

Der Abstand der Basiszonen 13 und der zweiten Emitterzonen 15 zueinander ist gekennzeichnet durch einen ersten Abstand d1. Der erste Abstand d1 beschreibt die Basisweite der Ansteuertransistoren T2. Über die Basisweite und somit über den ersten Abstand d1 läßt sich die Verstärkung der Ansteuertransistoren T2 einstellen. Typischerweise ist dieser Abstand in der SPT-Technologie größer als 20µm, bei Hochfrequenzanwendungen etwa 2µm.

Die Basiszonen 13 und die zweiten Emitterzonen 15 sind in dem Teilbereich 10' derart angeordnet, daß sie von den Abschlußzone 16 durch einen zweiten Abstand d2 beabstandet sind. Der zweite Abstand d2 ist dabei so groß zu wählen, daß der laterale, parasitäre npn-Bipolartransistor im Randbereich des Teilbereichs 10' unterdrückt wird.

Die die ersten Emitterzonen 14 enthaltenden Basiszonen 13 sowie die zweiten Emitterzonen 15 sind in der Epitaxieschicht 10 derart angeordnet, daß sie vertikal direkt über der vergrabenen Schicht 11 angeordnet sind und von der vergrabenen Schicht 11 beabstandet sind.

Die Dotierungskonzentration der Epitaxieschicht 10 sowie der dritte Abstand d3 zwischen vergrabener Schicht 11 und Basiszonen 13 gibt die Durchschaltspannung der Schalttransistoren T1 an.

Die Basiszonen 13 und die Emitterzonen 14, 15 sind im vorliegenden Beispiel wannenförmig ausgebildet. Es waren jedoch auch V-förmige, U-förmige, trenchförmige, oder ähnliche Strukturen denkbar. Diese Zonen 13, 14, 15 werden vorteilhafterweise durch Diffusion oder Ionenimplantation in den Halbleiterkörper 7 eingebracht. Es wäre jedoch auch eine alternative Herstellungsmöglichkeit, wie zum Beipiel eine Abscheidung oder ähnliches, denkbar.

Die Basiszonen 13 und die Emitterzonen 14, 15 sind über übliche Kontaktierungen 17, 18, 19 an der Scheibenoberfläche 12 kontaktiert. Dabei sind jeweils die ersten Kontaktelektroden 17 der ersten Emitterzonen 14 mit der zweiten Potentialschiene 3 und damit mit der Bezugsmasse verbunden. Die zweiten und dritten Kontaktelektroden 18, 19 der ersten Emitterzone 14 und der Anschlußzone 16 sind jeweils mit dem Anschlußpad 5 verbunden.

Zusätzlich ist in Figur 2 eine Pufferzone 20 vorgesehen, die sich von der Scheibenvorderseite 12 durch die gesamte Epitaxieschicht 10 bis in den Halbleiterkörper 7 hinein erstreckt. Im vorliegenden Beispiel besteht die Pufferzone 20 aus p-dotiertem Silicium. Die Pufferzone 20 kann jedoch auch durch jedes andere gängige Puffermaterial, beispielsweise Siliciumdioxid, Siliciumnitrit oder ähnlichem, gebildet werden. Die Pufferzone 20 hat üblicherweise die Funktion der Schirmung bzw. der Trennung der ESD-Schutzstrukturen gegenüber der integrierten Halbleiterschaltung 2 bzw. dem Halbleiterchip.

Besonders vorteilhaft ist es jedoch, wenn die Pufferzone 20 aus p+-dotiertem Silicium besteht. In diesem Fall kann die in Flußrichtung gepolte pn-Diode zwischen vergrabener Schicht 11 und p-dotiertem Substrat 7 genutzt werden, um beispielsweise negative Pulse abzuführen. Diese negativen Pulse können dann über die p+-dotierte Pufferzone 20 abgeleitet werden.

In Figur 2 ist schematischen das Ersatzschaltbild der erfindungsgemäßen ESD-Schutzstruktur in den Querschnitt des Halbleiterkörpers 7 eingezeichnet. Dieses ESD-Schutzstruktur besteht aus zwei Schalttransistoren T1 und zwei Ansteuertransistoren T2. Die Schalttransistoren sind im vorliegenden Beispiel npn-Bipolartransistoren, deren Emitter, Basis und Kollektor durch die ersten Emitterzonen 14, die Basiszonen 13 und die vergrabene Schicht 11 gebildet werden. Die Ansteuertransistoren T2 sind pnp-Bipolartransistoren, deren Emitter, Basis und Kollektor durch die zweiten Emitterzonen 15, die vergrabene Schicht 11 und die Basiszonen 13 gebildet werden.

Die Kollektoranschlüsse bzw. Basisanschlüsse der Schalttransistoren T1 und der Ansteuertransistoren T2 sind durch gegenseitige Kopplung zu einer Thyristorstruktur verschaltet. Die Ansteuertransistoren steuern die Schalttransistoren in den leitenden oder sperrenden Zustand.

Die vergrabene Schicht 11, die jeweils mit den Kollektoranschlüssen der Schalttransistoren T1 den Basisanschlüssen der Ansteuertransistoren T2 sind jeweils erste Widerstände R1. Die ersten Widerstände R1 sind durch den Leitwert in der vergrabenen Schicht 11 festgelegt.

Kollektorseitig sind zwischen den Schalttransistoren T1 und dem Anschlußpad 5 zweite Widerstände R2 vorgesehen. Die zweiten Widerstände R2 sind durch den Leitwert der Anschlußzonen 16 sowie durch Kontaktwiderständen festgelegt.

Typischerweise ist die laterale Querschnittsfläche der vergrabenen Schicht 11 mindestens größer als die von der Ringstruktur der Anschlußzone 16 eingeschlossene Querschnittsfläche. Die ringförmige Anschlußzone 16 sowie die vergrabene Schicht 11 sind aus praktischen Gründen quadratisch oder rechteckförmig ausgebildet. Es ist jedoch auch vorteilhaft, wenn diese Zonen 11, 16 kreisförmig bzw. rund ausgebildet sind. In letzterem Fall sind die Basiszonen 13 und Emitterzonen 14, 15 nicht fingerförmig angeordnet, sondern beispielsweise kreisringförmig ausgebildet.

Nachfolgend wird die Funktionsweise der erfindungsgemäßen ESD-Schutzstruktur näher erläutert.

Wird über das Anschlußpad 5 ein Störsignal eingekoppelt, und uberschreitet dieses Störsignal die Schaltschwelle der Ansteuertransistoren T2, dann bricht die Raumladungszone am pn-Ubergang der in Diodenschaltung geschalteten Ansteuertransistoren T2 zusammen. Die Ansteuertransistoren T2 schalten durch. Dadurch wird die Basis der Schalttransistoren T1 derart angesteuert, daß diese bei ausreichend hohem Ansteuerstrom ebenfalls leitend gesteuert werden. Somit ergibt sich ein Strompfad vom Anschlußpad 5 über die Anschlußzonen 16, die vergrabene Schicht 11, den Basiszonen 13, zu den Emitterzonen 14 und somit zur zweiten Potentialschiene 3. Das Störsignal wird somit auf die zweite Potentialschiene 3 abgeleitet und gelangt damit nicht in die integrierte Halbleiterschaltung 1.

ESD-Schutzelemente, die auf vertikalen npn-Bipolartransistoren beruhen und deren p-Basis mittels integrierter pnp-Bipolartransistoren (z.B. bei einer Zweifingerstruktur) angesteuert werden, zeigen gegenüber einer Konfiguration mit offener Basis eine um 50 % höhere Ausfallschwelle. Dies wird wie folgt erklärt: Es kommt zu einem lokalen Durchbruch des vertikalen npn-Transistors, der hier durch die Schalttransistoren T1 repräsentiert wird. Aurgrund des Spannungsabfalles an den Anschlußgebieten 16 und Kontakten der vergrabenen Schicht 11 und damit der Basisgebiete der lateralen pnp-Transistoren (Ansteuertransistoren T2) werden diese angesteuert. Aufgrund des hohen Leitwertes der vergrabenen Schicht 11 erfolgt dies gleichmäßig über die gesamte Weite der Ansteuertransistoren T2. Dadurch werden auch die übrigen lokalen Schalttransistoren T1 durchgeschaltet.

Bei der Dimensionierung der Ansteuertransistoren T2 ist darauf zu achten, daß es nicht zum Zünden eines lokalen Thyristors mit entsprechend inhomogener Stromverteilung und für die Schaltungseigenschaften ungeeignetem Zurückspringen der Kennlinie bis auf eine sehr niedrige Haltespannung von typischerweise etwa 1,4 V kommen kann.

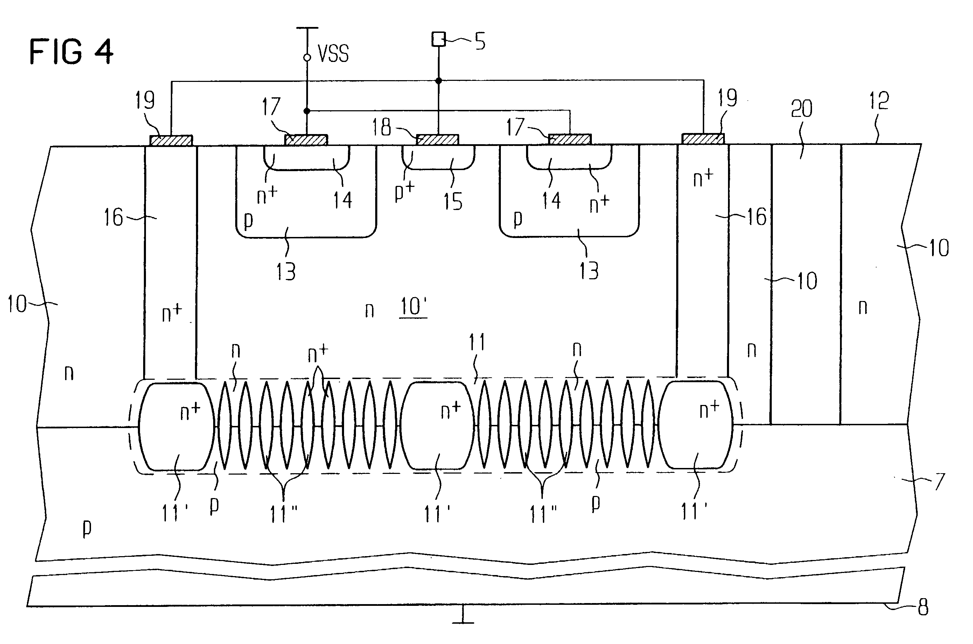

Die Figuren 3 und 4 zeigen zwei weitere Ausführungsbeispiele einer erfindungsgemäßen ESD-Schutzstruktur. Der besseren Übersichtlichkeit halber wurde auf die Darstellung des Ersatzschaltbildes in den Teilschnitten der Figuren 3 und 4 verzichtet.

Die ESD-Schutzstrukturen der Figuren 3 und 4 weisen im wesentlichen den selben Aufbau wie die ESD-Schutzstruktur der Figur 2 auf. Der wesentliche Unterschied der ESD-Schutzstrukturen in den Figuren 3 und 4 liegt in der Ausgestaltung der vergrabenen Schicht 11.

In Figur 3 weist die vergrabene Schicht 11 eine Vielzahl von homogen n⁺-dotierte Teilbereiche 11' auf. Die übrigen, nicht von Teilbereichen 11' eingenommenen Bereiche der vergrabenen Schicht 11 weisen typischerweise die Dotierung des Halbleiterkörpers 7 bzw. der Epitaxieschicht 10 auf.

In Figur 4 weist die vergrabene Schicht 11 ebenfalls n+dotierte Teilbereiche 11' auf. Diese Teilbereiche 11' sind hier zum einen vertikal unter der zweiten Emitterzone 15 angeordnet. Zum anderen kontaktieren diese Teilbereiche 11' die Anschlußzonen 16. In der vergrabenen Schicht 11 sind zwischen den Teilbereichen 11' weitere Teilbereiche 11'' angeordnet. Die weiteren Teilbereiche 11" sind hier sehr viel kleiner ausgebildet als die Teilbereiche 11'. Die Teilbereiche 11'' können streifenförmig, kugelförmig, etc. ausgebildet sein.

Teilbereiche 11' in Figur 3 sowie die Teilbereiche 11' und weitere Teilbereiche 11'' in Figur 4 sind typischerweise, jedoch nicht notwendigerweise nach deren Herstellung voneinander beabstandet. Die Teilbereiche 11' und weiteren Teilbereiche 11'' können durch Ionenimplantation bzw. auch durch Diffusion erzeugt werden. Um eine zumindest lokal homogene Dotierungskonzentration in der vergrabenen Schicht 11 zu erreichen, wird nach der Herstellung der Teilbereiche 11' und weiteren Teilbereiche 11'' typischerweise ein Temperaturschritt angeschlossen. Durch diesen Temperaturschritt wird in der ergrabenen Schicht 11 eine zumindest lokal homogene Dotierungskonzentration erzielt. Dabei weisen typischerweise die Teilbereiche 11' eine höhere Dotierungskonzentration als die weiteren Teilbereiche 11'' auf.

Durch die Bereitstellung einer ESD-Schutzstruktur entsprechend den Figuren 3 und 4 wird der erste Transistor T1 so konstruiert, daß die vergrabene Schicht 11 als strukturierte Implantation ausgebildet wird, um ohne einen zusätzlichen Prozeßschritt eine geeignete Einstellung der Dotierungskonzentration in der vergrabenen Schicht 11 zu erzielen. Da die Dicke der Epitaxieschicht 10 typischerweise so gewahlt wird, daß die Raumladungszone, die sich zwischen Basis und Kollektor des ersten Transistors T1 ausbildet, durch die vergrabene Schicht 11 begrenzt wird, kann durch eine niedrigere Dotierungskonzentration in der vergrabenen Schicht 11 eine höhere Durchbruchspannung bzw. auch eine höhere Haltespannung erzielt werden.

Wesentlich für die homogene Durchsteuerung des ersten Transistors T1 ist dabei ein gleichmäßiges Ansteuern des zweiten Transistors T2. Dies erfordert jedoch, daß der Basisanschluß des zweiten Transistors T2 in der vertikalen Projektion niederohmig ausgebildet ist. Dies läßt sich durch die erfindungsgemäße Strukturierung der vergrabenen Schicht 11 mittels der Teilbereiche 11' und weiteren Teilbereiche 11'' (siehe Figur 3 und 4) erreichen. Damit kann eine höhere Haltespannung gegenüber gleichartigen ESD-Schutzstrukturen mit vergleichbarer ESD-Festigkeit, die jedoch nicht die Strukturierung in der vergrabenen Schicht 11 aufweisen, erreicht werden. Die ESD-Schutzstrukturen gemäß den Figuren 3 und 4 lassen somit eine bessere Einstelibarkeit der Haltespannung zu.

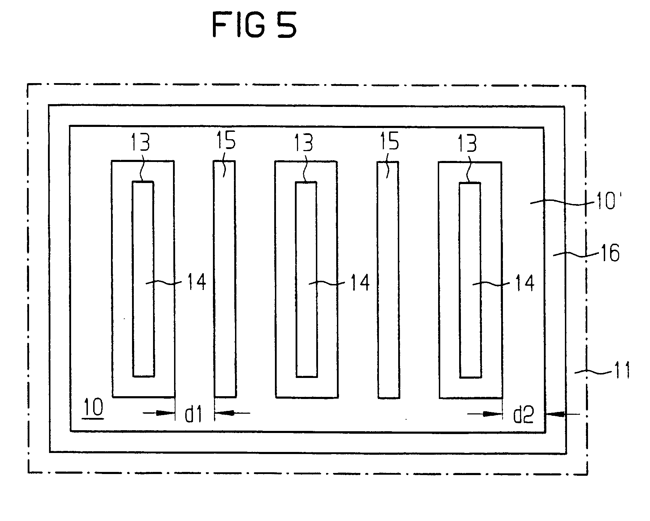

Figur 5 zeigt eine Draufsicht der Fingerstruktur entsprechend Figur 2. Zur besseren Übersicht wurden hier die Elektroden 17, 18, 19 sowie die Verbindungsleitungen nicht eingezeichnet.

Die Fingerstruktur in Figur 3 besteht aus drei Basiszonen 13, in denen jeweils erste Emitterzonen 14 mittig angeordnet sind. Zwischen jeweils benachbarten Basiszonen 13 sind äquidistant zweite Emitterzonen 15 angeordnet. Der Abstand zwischen Basiszonen 13 und zweiten Emitterzonen 15 ist durch den ersten Abstand d1 gegeben. Der zweite Abstand d2 beschreibt den Abstand der Basiszonen 13 bzw. zweiten Emitterzonen 15 zur Anschlußzone 16. Die Anschlußzone 16 umschließt die Basiszonen 13 sowie Emitterzonen 14, 15 ringförmig. Dieser ringförmige Bereich definiert den Teilbereich 10'.

Des weiteren ist in Figur 5 die Lage der vergrabenen Schicht 11 gestrichelt angedeutet. Die laterale Querschnittsfläche der vergrabenen Schicht 11 muß dabei, wie angedeutet, mindestens so groß sein, wie die durch die ringförmige Abschlußzone 16 eingeschlossene laterale Querschnittsfläche.

Wie in Figur 5 gezeigt, sind die ringförmige Anschlußzone 16 und damit auch der Teilbereich 10', der die Fingerstruktur beinhaltet, rechteckig ausgebildet. Um eine homogene Verteilung des elektrischen Feldes zu erzielen, ist es vorteilhaft, daß das Anschlußgebiet 16, die vergrabene Schicht 11 sowie die Basiszonen 13 und Emitterzonen 14, 15 der Fingerstruktur an ihren Kanten bzw. Ecken rund ausgeformt sind.

Besonders vorteilhaft ist die Erfindung bei Verwendung des ESD-Schutzelements in einem Mikrocontroller, in einem Halbleiterspeicher oder in einem Logikbauteil.

Die integrierte Halbleiterschaltung sowie das dazugehörige ESD-Schutzelement sind dabei vorzugsweise bipolar realisiert: bzw. in Smart-Power-Technologie hergestellt. Besonders vorteilhaft ist es jedoch auch, wenn die integrierte Halbleiterschaltung 1 sowie die ESD-Schutzschaltung in CMOS-Technologie hergestellt ist.

## Patentansprüche

1. Integrierte Halbleiterschaltung (1), die in zumindest einem Halbleiterkörper (7) angeordnet ist,
a) mit mindestens einem Anschlußpad (5), das über eine elektrisch leitende Verbindungsleitung (4) mit der integrierten Halbleiterschaltung (1) verbunden ist,
b) mit mindestens einer ersten Potentialschiene (2), die im Betrieb ein erstes Versorgungspotential (VCC) der integrierten Halbleiterschaltung (1) führt,
c) mit mindestens einer zweiten Potentialschiene (3), die im Betrieb ein zweites Versorgungspotential (VSS) der integrierten Halbleiterschaltung (1) führt,
d) mit mindestens einem Schutzelement (6) zum Schutz der integrierten Halbleiterschaltung (1) vor elektrostatischer Entladung, wobei das Schutzelement (6) zwischen das Anschlußpad (5) und der integrierten Halbleiterschaltung (1) angeordnet ist und an mindestens eine der Potentialschienen (2, 3) angeschlossen ist und wobei das Schutzelement (6) eine Anzahl von ersten Transistoren (T1) mit Majoritätsladungsträgern vom ersten Leitungstyp und eine Anzahl von zweiten Transistoren (T2) mit Majoritätsladungsträgern vom zweiten Leitungstyp aufweist, die durch gegenseitige Kopplung ihrer Basisanschlüsse und ihrer Kollektoranschlüsse zu einer Thyristorstruktur verschaltet sind,
e) mit mindestens einer vergrabenen Schicht (11), die einen ersten integrierten Widerstand (R1) aufweist und die die Basisanschlüsse der zweiten Transistoren (T2) und die Kollektoranschlüsse der ersten Transistoren (T1) bildet,
**dadurch gekennzeichnet,**
**daß**
f) in der vergrabenen Schicht als ein erster integrierter und niederohniger Widerstand (11) eine Mehrzahl von nebeneinander angeordneten und voneinander beabstandeten Teilbereiche (11', 11'') eine höhere Dotierungskonzentration aufweisen als die keine Teilbereiche (11', 11'') enthaltenden Bereiche der vergrabenen Schicht (11).

2. Integrierte Halbleiterschaltung nach Anspruch 1,
**dadurch gekennzeichnet,**
**daß** die Schutzelemente (6) in einem Teilbereich (10') oberhalb der vergrabenen Schicht (11) angeordnet sind, der folgende Merkmale aufweist:
- mindestens eine Basiszone (13) vom ersten Leitungstyp, die wannenförmig ausgebildet sind und die die Basisanschlüsse der Schalttransistoren (T1) sowie die Kollektoranschlüsse der Ansteuertransistoren (T2) bildet,
- mindestens eine erste Emitterzone (14) vom zweiten Leitungstyp, die wannenförmig ausgebildet sind, die in den Basiszonen angeordnet sind und die die Emitteranschlüsse jeder Schalttransistoren (T1) bildet,
- mindestens eine zweite Emitterzone (15) vom ersten Leitungstyp, die wannenförmig ausgebildet ist, die von den Basiszonen (13) durch einen ersten Abstand (d1) beabstandet ist und die die Emitteranschlüsse der Ansteuertransistoren (T2) bildet.

3. Integrierte Halbleiterschaltung nach Anspruch 1,
**dadurch gekennzeichnet,**
**daß** der Leitwert des ersten Widerstandes (R1) von der Dotierungskonzentration in der vergrabenen Schicht (11) festgelegt ist.

4. Integrierte Halbleiterschaltung nach einem der vorhergehenden Ansprüche,
**dadurch gekennzeichnet,**
**daß** die ersten Transistoren (T1) Schalttransistoren sind und die zweiten Transistoren (T2) Ansteuertransistoren zur Ansteuerung der Schalttransistoren sind.

5. Integrierte Halbleiterschaltung nach Anspruch 4,
**dadurch gekennzeichnet,**
**daß** die Basis-Kollektor-Verstärkung der Ansteuertransistoren (T2) kleiner ist als die der Schalttransistoren (T1).

6. Integrierte Halbleiterschaltung nach einem der Ansprüche 4 oder 5 in Verbindung mit Anspruch 2,
**dadurch gekennzeichnet,**
**daß** die Basis-Kollektor-Verstärkung der Ansteuertransistoren (T2) durch den ersten Abstand (d1) festgelegt ist.

7. Integrierte Halbleiterschaltung nach einem der Ansprüche 1 bis 6,
**dadurch gekennzeichnet,**
**daß** mindestens eine Anschlußzone (16) vorgesehen ist, die an die vergrabene Schicht (11) angeschlossen ist und die mit dem Anschlußpad (5) verbunden ist.

8. Integrierte Halbleiterschaltung nach Anspruch 7,
**dadurch gekennzeichnet,**
**daß** die Anschlußzone (16) äquidistant durch einen zweiten Abstand (d2) von den Basiszonen (13) und/oder den zweiten Emitterzonen (15) beabstandet ist.

9. Integrierte Halbleiterschaltung nach einem der Ansprüche 7 oder 8,
**dadurch gekennzeichnet,**
**daß** in der Anschlußzone (16) ein zweiter integrierter Widerstand (R2) vorgesehen ist, dessen Leitwert von der Dotierungskonzentration in den Anschlußzonen (16) eingestellt ist.

10. Integrierte Halbleiterschaltung nach einem der Ansprüche 7 bis 9,
**dadurch gekennzeichnet,**
**daß** die Anschlußzone (16) als geschlossener Ring um die Teilzone (10') angeordnet ist.

11. Integrierte Halbleiterschaltung nach einem der Ansprüche 7 bis 10,
**dadurch gekennzeichnet,**
**daß** die laterale Querschnittsfläche der vergrabenen Schicht (11) größer ist als die laterale Querschnittsfläche, die sich aus der Anschlußzone (16) und dem Teilbereich (10') ergibt.

12. Integrierte Halbleiterschaltung nach einem der Ansprüche 2 bis 11,
**dadurch gekennzeichnet,**
**daß** der Teilbereich (10') in einer Epitaxieschicht (10) des Halbleiterkörpers (7) angeordnet ist.

13. Integrierte Halbleiterschaltung nach einem der Ansprüche 2 bis 12,
**dadurch gekennzeichnet,**
**daß** die erste Emitterzone (14) eine höhere Dotierungskonzentration aufweist als die Basiszone (13).

14. Integrierte Halbleiterschaltung nach einem der Ansprüche 1 bis 13,
**dadurch gekennzeichnet,**
**daß** die maximale Dotierungskonzentration in der vergrabenen Schicht (11) mindestens 1*10¹⁹ cm⁻³ beträgt.

## Claims

1. Integrated semiconductor circuit (1), which is arranged in at least one semiconductor body (7),
a) having at least one terminal pad (5), which is connected via an electrically conductive connecting line (4) to the integrated semiconductor circuit (1),
b) having at least one first busbar (2), which carries a first supply potential (VCC) of the integrated semiconductor circuit (1) during operation,
c) having at least one second busbar (3), which carries a second supply potential (VSS) of the integrated semiconductor circuit (1) during operation,
d) having at least one protective element (6) for protecting the integrated semiconductor circuit (1) against electrostatic discharge, the protective element (6) being arranged between the terminal pad (5) and the integrated semiconductor circuit (1) and being connected to at least one of the busbars (2, 3), and the protective element (6) having a number of first transistors (T1) with majority charge carriers of the first conduction type and a number of second transistors (T2) with majority charge carriers of the second conduction type, which are connected up to form a thyristor structure by reciprocal coupling of their base terminals and of their collector terminals,
e) having at least one buried layer (11) resistor (R1), which has a first integrated resistor (R1) and which forms the base terminals of the second transistors (T2) and the collector terminals of the first transistors (T1),
f) in the buried layer (11), as a first integrated and low-value resistant, a plurality of partial regions (11', 11'') arranged next to one another and spaced apart from one another have a higher doping concentration than those regions of the buried layer (11) which do not contain partial regions (11', 11'').

2. Integrated semiconductor circuit according to claim 1,
**characterized**
**in that** the protective elements (6) are arranged in a partial region (10') above the buried layer (11) and having the following features:
- at least one base zone (13) of the first conduction type, which are designed in the form of wells and which forms the base terminals of the switching transistors (T1) and the collector terminals of the driving transistors (T2),
- at least one first emitter zone (14) of the second conduction type, which are designed in the form of wells, which are arranged in the base zones and which forms the emitter terminals of every one of the switching transistors (T1),
- at least one second emitter zone (15) of the first conduction type, which is designed in the form of wells, which is spaced apart from the base zones (13) by a first distance (d1) and which forms the emitter terminals of the driving transistors (T2).

3. Integrated semiconductor circuit according to Claim 1,
**characterized**
**in that** the conductance of the first resistor (R1) is defined by the doping concentration in the buried layer (11).

4. Integrated semiconductor circuit according to one of the preceding claims,
**characterized**
**in that** the first transistors (T1) are switching transistors and the second transistors (T2) are driving transistors for driving the switching transistors.

5. Integrated semiconductor circuit according to Claim 4,
**characterized in that**
the base-collector gain of the driving transistors (T2) is less than that of the switching transistors (T1).

6. Integrated semiconductor circuit according to either of Claims 4 and 5,
**characterized**
**in that** the base-collector gain of the driving transistors (T2) is defined by the first distance (d1).

7. Integrated semiconductor circuit according to one of Claims 1 to 6,
**characterized**
**in that** at least one connection zone (16) is provided which is connected to the buried layer (11) and to the terminal pad (5).

8. Integrated semiconductor circuit according to Claim 7,
**characterized**
**in that** the connection zone (16) is spaced equidistantly from the base zones (13) and/or the second emitter zones (15) by a second distance (d2).

9. Integrated semiconductor circuit according to either of Claims 7 and 8,
**characterized**
**in that** a second integrated resistor (R2) is provided, whose conductance is set by the doping concentration in the connection zones (16).

10. Integrated semiconductor circuit according to one of Claims 7 to 9,
**characterized**
**in that** the connection zone (16) is arranged as a closed ring around the partial zone (10').

11. Integrated semiconductor circuit according to one of Claims 7 to 10,
**characterized**
**in that** the lateral cross-sectional area of the buried layer (11) is larger than the lateral cross-sectional area which results from the connection zone (16) and the partial region (10').

12. Integrated semiconductor circuit according to one of Claims 2 to 11,
**characterized**
**in that** the partial region (10') is arranged in an epitaxial layer (10) of the semiconductor body (7).

13. Integrated semiconductor circuit according to one of Claims 2 to 12,
**characterized**
**in that** the first emitter zone (14) has a higher doping concentration than the base zone (13).

14. Integrated semiconductor circuit according to one of Claims 1 to 13,
**characterized**
**in that** the maximum doping concentration in the buried layer (11) is at least 1*10¹⁹ cm⁻³.

## Revendications

1. Circuit à semi-conducteur intégré (1) disposé dans au moins un corps semi-conducteur (7), comprenant
a) au moins une voie de raccordement (5) qui est reliée au circuit à semi-conducteur intégré (1) par l'intermédiaire d'une ligne de liaison (4) à conduction électrique,
b) au moins une première barre de potentiel (2) qui conduit pendant le fonctionnement un premier potentiel d'alimentation (VCC) du circuit à semi-conducteur intégré (1),
c) au moins une deuxième barre de potentiel (3) qui conduit pendant le fonctionnement un deuxième potentiel d'alimentation (VSS) du circuit à semi-conducteur intégré (1),
d) au moins un élément de protection (6) pour protéger le circuit à semi-conducteur intégré (1) contre les décharges électrostatiques, l'élément de protection (6) étant disposé entre la voie de raccordement (5) et le circuit à semi-conducteur intégré (1) et raccordé à au moins l'une des barres de potentiel (2, 3), et l'élément de protection (6) présentant un nombre de premiers transistors (T1) avec des porteurs de charge majoritaires du premier type de conduction et un nombre de deuxièmes transistors (T2) avec des porteurs majoritaires de charge du deuxième type de conduction qui constituent une structure à thyristor grâce au couplage réciproque de leurs raccordements de base et de leurs raccordements de collecteur,
e) au moins une couche enfouie (11) qui présente une première résistance intégré (R1) et qui constitue les raccordements de base des deuxièmes transistors (T2) et les raccordements de collecteur des premiers transistors (T1),
**caractérisé en ce que**
f) dans la couche enfouie (11), en tant que première résistance intégrée et à basse impédance, une multitude de zones partielles (11', 11") juxtaposées et à distance les unes des autres présentent une concentration de dopage plus importante que les zones de la couche enfouie (11) ne comprenant pas de zones partielles (11', 11").

2. Circuit à semi-conducteur intégré selon la revendication 1, **caractérisé en ce que** les éléments de protection (6) sont disposés dans une zone partielle (10') située au-dessus de la couche enfouie (11) et présentent les caractéristiques suivantes :
- au moins une zone de base (13) du premier type de conduction, configurée en forme de cuve et constituant les raccordements de base des transistors de commutation (T1) ainsi que les raccordements de collecteur des transistors de commande (T2),
- au moins une première zone d'émetteur (14) du deuxième type de conduction, configurée en forme de cuve, disposée dans les zones de base et constituant les raccordements d'émetteur de chaque transistor de commutation (T1),
- au moins une deuxième zone d'émission (15) du premier type de conduction, configurée en forme de cuve, disposée à une première distance (d1) par rapport aux zones de base (13) et constituant les raccordements d'émetteur des transistors de commande (T2).

3. Circuit à semi-conducteur intégré selon la revendication 1, **caractérisé en ce que** la conductance de la première résistance (R1) est définie par la concentration de dopage dans la couche enfouie (11).

4. Circuit à semi-conducteur intégré selon l'une des revendications précédentes, **caractérisé en ce que** les premiers transistors (T1) sont des transistors de commutation et que les deuxièmes transistors (T2) sont des transistors de commande pour commander les transistors de commutation.

5. Circuit à semi-conducteur intégré selon la revendication 4, **caractérisé en ce que** le gain collecteur de base des transistors de commande (T2) est inférieur à celui des transistors de commutation (T1).

6. Circuit à semi-conducteur intégré selon l'une des revendications 4 ou 5 en relation avec la revendication 2, **caractérisé en ce que** le gain collecteur de base des transistors de commande (T2) est défini par la première distance (d1).

7. Circuit à semi-conducteur intégré selon l'une des revendications 1 à 6, **caractérisé en ce qu'**au moins une zone de raccordement (16) est prévue, qui est connectée à la couche enfouie (11) et qui est reliée à la voie de raccordement (5).

8. Circuit à semi-conducteur intégré selon la revendication 7, **caractérisé en ce que** la zone de raccordement (16) est équidistante d'une deuxième distance (d2) des zones de base (13) et/ou des deuxièmes zones d'émetteur (15).

9. Circuit à semi-conducteur intégré selon l'une des revendications 7 ou 8, **caractérisé en ce que** dans la zone de raccordement (16) une deuxième résistance intégrée (R2) est prévue, dont la conductance est réglée par la concentration de dopage dans les zones de raccordement (16).

10. Circuit à semi-conducteur intégré selon l'une des revendications 7 à 9, **caractérisé en ce que** la zone de raccordement (16) est disposée en tant qu'anneau fermé autour de la zone partielle (10').

11. Circuit à semi-conducteur intégré selon l'une des revendications 7 à 10, **caractérisé en ce que** la superficie de section latérale de la couche enfouie (11) est plus grande que la superficie de section latérale résultant de la zone de raccordement (16) et de la zone partielle (10').

12. Circuit à semi-conducteur intégré selon l'une des revendications 2 à 11, **caractérisé en ce que** la zone partielle (10') est disposée dans une couche épitaxiale (10) du corps semi-conducteur (7).

13. Circuit à semi-conducteur intégré selon l'une des revendications 2 à 12, **caractérisé en ce que** la première zone d'émetteur (14) présente une concentration de dopage plus importante que la zone de base (13).

14. Circuit à semi-conducteur intégré selon l'une des revendications 1 à 13, **caractérisé en ce que** la concentration de dopage maximale dans la couche enfouie (11) est d'au moins 1*10¹⁹ cm⁻³.
